# EUROPÄISCHE PATENTANMELDUNG

(11) **EP 2 985 912 A1**
(43) Veröffentlichungstag der Anmeldung: **17.02.2016**
(21) Anmeldenummer: 15176948.6
(22) Anmeldetag: 16.07.2015
(51) Int. Cl.: H03K 17/96

(54) **BEDIENVORRICHTUNG MIT EINEM BLENDENTEIL UND ELEKTRISCHES GERÄT**

(30) Priorität: 13.08.2014 DE 102014111560
(71) Anmelder: Miele & Cie. KG, 33332 Gütersloh (DE)
(72) Erfinder: Schneider, Daniel, 33415 Verl (DE); Evertzberg, Frank, 33428 Marienfeld (DE)

(57) **Zusammenfassung**

Die Erfindung betrifft eine Bedienvorrichtung (5) für ein elektrisches oder elektronisches Gerät (1), umfassend ein Blendenteil (6) mit Betätigungsflächen (7), einer Steuereinrichtung (4) und einer Anordnung von Sensoren (7), die jeweils den Betätigungsflächen (7) zugeordnet sind und dazu ausgebildet sind, eine elektrische Größe wie Kapazität oder Widerstand zu erfassen und als Schaltsignal zur Auswertung der Schaltposition der Steuereinrichtung (4) zuzuführen. Um die Bedienung insgesamt hinsichtlich Zuverlässigkeit und Haptik zu verbessern, ist zumindest ein weiterer Sensor (9) vorgesehen, der dazu ausgebildet ist, eine Kraftbeaufschlagung auf die Blende (6) bzw. auf eine der jeweiligen Betätigungsfläche (7) zu erfassen und als weiteres Signal (FS) der Steuereinrichtung (4) zuzuführen zu einer zusätzlichen Bewertung des Bedienereignisses.

## Beschreibung

Die Erfindung betrifft eine Bedienvorrichtung für ein elektrisches oder elektronisches Gerät, umfassend ein Blendenteil mit Betätigungsflächen, einer Steuereinrichtung und einer Anordnung von Sensoren, die jeweils den Betätigungsflächen zugeordnet sind und dazu ausgebildet sind, bei Berührung oder Kraftbeaufschlagung einer Schaltfläche oder bei Annäherung an eine Schaltfläche eine elektrische Größe wie beispielsweise Kapazität, Widerstand, Strom oder Spannung zu erfassen und als Schaltsignal zur Auswertung der Schaltposition der Steuereinrichtung zuzuführen.

Elektrische Geräte, wie Haushaltgeräte oder gewerbliche Waschmaschinen oder gewerbliche Trockner besitzen eine Bedienvorrichtung, die besonders robust aufgebaut und einfach zu bedienen ist. Dabei sind besonders Bedienvorrichtungen mit Tasten oder Berührflächen beliebt, da sie eine aufgeräumte Blende ermöglichen mit einer übersichtlichen Anzahl an Bedienmöglichkeiten. Bei besonders robust ausgebildeten Geräten kommen Blenden aus Edelstahl zum Einsatz, die besonders einfach zu reinigen sind und daher auch gewisse Hygieneanforderungen erfüllen.

Ein weiterer Vorteil in diesem Zusammenhang ist, dass die Blenden keinerlei Durchbrüche für mechanische Tasten haben und deshalb gut zu reinigen sind.

So ist aus der EP 1 641 010 A1 eine Bedienvorrichtung für ein elektrisches Gerät bekannt, die Schaltflächen umfasst, die durch eine Kraftbeaufschlagung mit einem innerhalb der Bedienvorrichtung angebrachten Sensoren derart zusammenwirkt, dass eine Betätigung entsprechend sensiert wird. Hierbei kann es vorkommen, dass der Bediener eine Verformung der Blendenoberfläche entweder nicht wahrnimmt und somit durch mehrmalige Betätigungen das elektrische Gerät fehlbedient oder dass eine spürbare Verformung oder Verwindung der Bedienfläche bzw. der Blende als unangenehm empfunden wird.

Eine Bedienvorrichtung mit Betätigungsflächen als Berührflächen ist aus der DE 10 2007 026 857 A1 bekannt. Hierbei ist im Blendenteil eine Leiterplatte mit den Kontaktflächen bzw. Sensoren angeordnet, die mittels Federn an der Innenseite des Blendenteils elektrisch verbunden sind. Eine Berührung bzw. Annäherung an der jeweils außenseitigen Berührfläche führt zu einer Kapazitätsänderung des Sensors, die entsprechend als Schaltvorgang erfasst und weiterverarbeitet wird.

Der Erfindung liegt somit die Aufgabe zu Grunde, eine Bedienvorrichtung für ein elektrisches Gerät zu schaffen, die bei einfachem Aufbau sicher und zuverlässig funktioniert und die eine verbesserte Haptik dem Benutzer vermittelt.

Erfindungsgemäß wird zumindest diese Aufgabe durch eine Bedienvorrichtung mit den Merkmalen des unabhängigen Anspruchs 1 und durch ein elektrisches Gerät gemäß dem unabhängigen Anspruch xx gelöst. Vorteilhafte Ausgestaltungen und Weiterbildungen der Erfindung ergeben sich aus den jeweils nachfolgenden abhängigen Ansprüchen.

Ein relevanter Vorteil besteht darin, dass dem Bediener eine bewusste Bedienhandlung zur Betätigung einer Schaltfläche abverlangt wird. Fehlbedienungen aufgrund einer zufälligen Berührung einer berührsensitiven Schaltfläche können nicht mehr vorkommen. Ferner kann die Darbietung von Bedienhandlungen dahingehend verbessert werden, dass bei Berührung der Schaltfläche ein optischer oder akustischer Hinweis über diese Anwahl erfolgt, wobei erst bei der bewussten Druckausübung auf die entsprechende Schaltfläche die Anwahl zur Ausführung in der Steuereinrichtung übernommen wird bzw. die angewählte Aktion gestartet wird. Die wird auf einfache Weise durch zumindest einen weitern Sensor erreicht, der dazu ausgebildet ist, eine Kraftbeaufschlagung auf die Blende bzw. einer der jeweiligen Betätigungsfläche zu erfassen und als weiteres Signal der Steuereinrichtung zuzuführen zu einer zusätzlichen Bewertung des Bedienereignisses. Im einfachsten Fall reicht ein einziger Sensor aus, um einen Druck auf eine beliebige von mehreren Schaltflächen als Bedienereignis zu erfassen bzw. als solches zu beurteilen. Die Bedienblende ist dabei als Touchblende, mit Touchflächen oder als Touchscreen, ausgebildet, wobei die Auswertung und Erkennung der Berührstelle auf die bereits bewährte Art und Weise erfolgt.

Die erfindungsgemäße Anordnung kann für alle üblichen Touch-Blenden zum Einsatz kommen, beispielsweise bei denen es bei einer Betätigung durch Berührung oder Annäherung zu einer Kapazitätsänderung kommt (kapazitive Sensoren) oder bei denen es bei einer Betätigung zu einer Veränderung z.B. des Photostromes kommt (optische Sensoren oder bei denen es bei einer Betätigung zu einer Änderung der Induktivität kommt (induktive Sensoren).

In einer zweckmäßigen Ausführung ist der zusätzliche Sensor zumindest ein Kraftsensor, der dazu geeignet und ausgebildet ist, eine Kraftbeaufschlagung auf der Außenseite des Blendenteils zu erfassen. Dabei kann auch ein Wegsensor verwendet werden, der eine entsprechende Ortsveränderung der Blende bei Druckbeaufschlagung durch den Betätigungsdruck erfasst und als Schaltsignal der Steuereinrichtung zur Auswertung des Bedienereignisses zuführt.

In einer insgesamt vorteilhaften Ausführung weist das Blendenteil Mittel zur schwimmenden Lagerung oder Kopplung an einem Gehäuse des elektrischen Gerätes auf. Damit ist eine definierte Bewegung, insbesondere eine Hubbewegung der Blende sichergestellt, die eine sicherere Erfassung eines Drucks auf die Blende ermöglicht.

In einer vorteilhaften Weiterbildung ist als Mittel zur schwimmenden Lagerung eine elastische Dichtung zur Anlage des Blendenteils an dem feststehenden Gehäuse des Gerätes vorgesehen. Damit wird gleichzeitig eine Abdichtung des Blendenteils zum Gehäuse bereitgestellt. Als Dichtung kann dabei ein umlaufender Elastomerring verwendet werden oder eine zwischen Gehäuse und Blende verlaufende Fuge eingespritzte Dichtmasse, beispielsweise Silikon oder Acryl.

Alternativ oder in Kombination dazu sind in einer weiteren Ausführung als Mittel zur schwimmenden Lagerung federnde Befestigungselemente, beispielsweise Schraubfedern oder Blattfedern aus Metall, vorgesehen. Federn aus Metall sind hinsichtlich der Bereitstellung von Bewegungen oder einer schwimmenden Lagerung reaktionsschnell und altersbeständig.

In einer weiteren oder alternativen Ausführung ist das Blendenteil als verformbare Platte ausgebildet. Dadurch ergibt sich partielle Verformung bei Kraftbeaufschlagung auf die Außenfläche der Blende, die mit dem Kraftsensor oder Wegsensor sensiert werden kann.

Insgesamt ist es vorteilhaft, die Verformbarkeit bzw. Bewegung des Blendenteils senkrecht zur Außenfläche des Blendenteils in einem Bereich von 0,2 mm bis 2 mm vorzusehen. Damit wird sichergestellt, dass der Benutzer ein Eindrücken der Blende in Richtung Gehäuseinneres deutlich als taktiles Erlebnis wahrnimmt.

Es ist insgesamt zweckmäßig, dass der Kraftsensor an der Blende angekoppelt und ferner zur Kopplung mit dem ortsfesten Gehäuse des Gerätes ausgebildet ist, um in betriebsgemäßem Zustand eine Verformung oder Bewegung der Blende in Richtung Tastflächenbetätigung, also quer zur Erstreckung der Außenfläche der Blende , zu erfassen. Als betriebsgemäßer Zustand ist der im Gerät eingebaute Zustand der Blende bzw. der Bedieneinrichtung in betriebsgemäßer Lage des elektrischen Gerätes anzusehen.

In einer insgesamt vorteilhaften Weiterbildung der Erfindung oder der genannten Ausführungen ist der weitere Sensor dazu ausgebildet, eine Verformung oder Bewegung der Blende beim Eindrücken und eine entgegengesetzte Bewegung oder Verformung der Blende beim Loslassen zur Bestimmung des Bedienereignisses zu erfassen. Damit können Bedienabläufe oder Bedienhandlungen, wie sie mit Tastschaltern möglich sind, auf einfache Weise nachempfunden werden.

Um die Druckerfassung sicher bereitzustellen, ist es zweckmäßig, dass der Kraftsensor rückseitig im mittleren Bereich mit der Blende gekoppelt oder befestigt ist, bezogen auf die Erstreckung der Blende von einem seitlichen Ende zum gegenüberliegendem seitlichen Ende der Blende.

In einer anderen, vorteilhaften Ausführung ist der Kraftsensor rückseitig an einem seitlichen Ende der Blende und ein weiterer Kraftsensor () rückseitig am gegenüberliegenden, seitlichen Ende der Blende (6) gekoppelt oder befestigt. Damit wird bei schmalen, langen Blenden mit einer über die Länge verteilten Schaltflächen eine sichere Erfassung der Kraftbeaufschlagung auf die Blendenfläche bereitgestellt.

In einer insgesamt vorteilhaften Ausführung der Erfindung umfasst die Bedienvorrichtung ein akustisches Ausgabemittel welches dazu ausgebildet ist, ein akustisches Signal im erfassten Betätigungsfall auszugeben. Damit wird das Betätigungserlebnis dadurch verstärkt, dass zusätzlich zu spürbaren Eindrücken der Blende oder Berühren der Blende beispielsweise ein "Klick"- Geräusch oder anderes signifikantes Betätigungsgeräusch erzeugt und vom Bediener vernommen wird. Dem Benutzer wird damit praktisch eine als robust empfundene Rückmeldung für seine Bedienhandlung gegeben.

Die Erfindung betrifft ferner ein Elektrisches Gerät (1), wie Gargerät (1), Getränkebereiter, Waschmaschine, Trockner, Geschirrspüler oder Desinfektionsgerät, umfassend eine Bedieneinrichtung (5) wie vorstehend beschrieben, die mit einer Steuereinrichtung (4) in Wirkverbindung steht zur Einstellung und zum Betreiben des elektrischen Gerätes. Dabei kann der Sensor zur Erfassung einer Krafteinwirkung am Gehäuse des Gerätes befestigt werden, wobei mit Hilfe eines Kopplungsmittels, wie einem Stößel, die Kopplung zur Innenseite der Blende erfolgt.

In einer insgesamt weckmäßigen Ausführung ist die Blende direkt bzw. unmittelbar mit dem Sensor gekoppelt bzw. verbunden, wobei es hierbei besonders vorteilhaft ist, wenn jeweils ein Sensor an einem seitlichen Rand und ein weiterer Sensor am gegenüberliegenden seitlichen Rand der Blende angebracht ist.

Ein Ausführungsbeispiel der Erfindung ist in den Zeichnungen rein schematisch dargestellt und wird nachfolgend näher beschrieben. Es zeigen
- Fig. 1: als elektrisches Gerät ein Gargerät bzw. Backofen
- Fig. 2: eine Bedienblende in einer Detailansicht;
- Fig. 3:: die Bedienblende in einer skizzierten Ansicht von der Innenseite und
- Fig. 4:: beispielhaft den Ablauf einer Bedienhandlung als Diagramm.

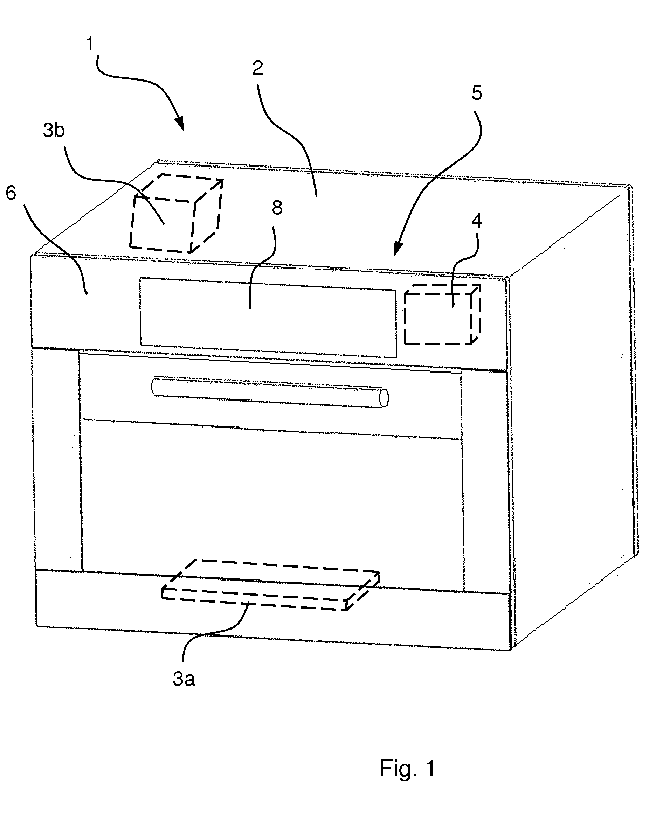

Das elektrische Gerät 1 gemäß Fig. 1 umfasst in diesem Beispiel Gehäuse 2 und die elektrisch betriebenen Komponenten 3 und eine Steuereinrichtung 4 zum Betrieb des Gerätes. 1 Hierbei handelt es sich um einen Backofen, der als Einbaugerät ausgeführt ist, sodass die Steuereinrichtung 4 anhand von Benutzereingaben zur Durchführung eines Garprogramms die elektrischen oder elektronischen Komponenten bzw. Lasten 3, wie Heizkörper 3a, Gebläse 3b oder Mikrowellensender 3c entsprechend aktiviert oder deaktiviert. Das elektrische Gerät 1 umfasst ferner eine Bedienvorrichtung 5, die eine für den Benutzer zugängliche Blende 6 mit daran angeordneten Schaltflächen bzw. Betätigungsflächen 7 umfasst. Der Benutzer kann durch Betätigung der Schaltflächen 7 vorbestimmte Programme, wie sogenannte automatische Garprogramme oder Parametereinstellungen vornehmen, die dann von der Steuereinrichtung 4 entsprechend verarbeitet werden. In dem gezeigten Beispiel ist die Bedienvorrichtung 5 mit einer senkrechten Blende 6 versehen, die im vorderen oberen Bereich des Gerätes 1 bzw. Gerätegehäuse 2 angebracht ist. Die Blende 6 kann alternativ oder kombiniert als schräge oder bombierte Blende 6 im oder am Gehäuse 2 angeordnet werden.

Die Steuereinrichtung 4 wirkt hierbei mit der Bedieneinrichtung 5 zusammen bzw. kann Bestandteil der Bedieneinrichtung 5 sein, da zur Auswertung der Bedienhandlung die Steuereinrichtung 4 verwendet wird. Alternativ kann die Bedieneinrichtung 5 eine separate Steuerung mit eigenem Mikrocontroller enthalten, der mit der Gerätesteuerung 4 zusammenwirkt bzw. mit dieser in Kommunikationsverbindung steht.

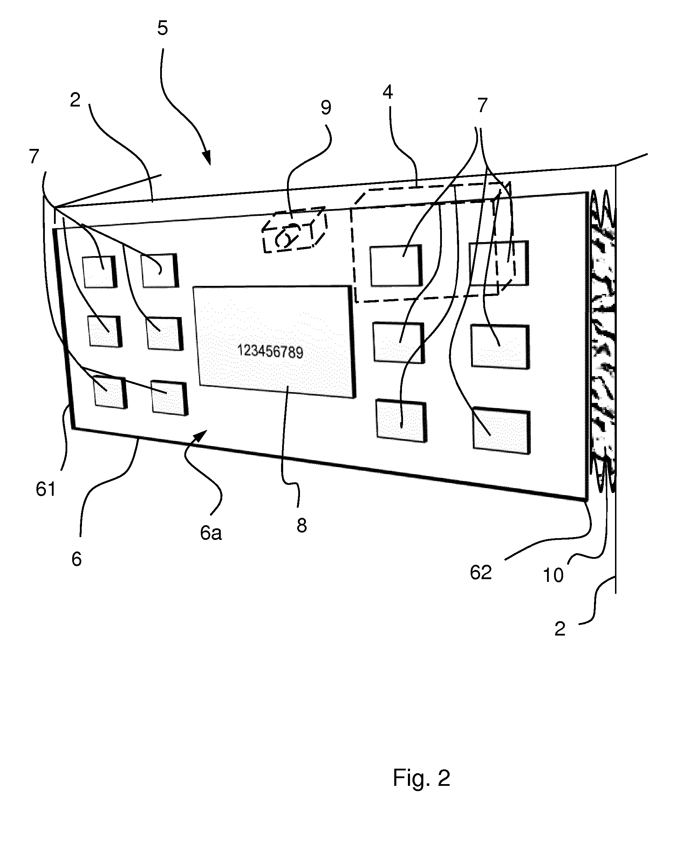

Fig. 2 zeigt in einer Detailansicht die Bedienvorrichtung 5, die die Blende 6 mit den Tastflächen 7 und einem Display 8 zeigt. Die Blende 6 ist dabei am Gehäuse 2 angebracht und ist ferner rückseitig, also gegenüberliegend der Außenfläche 6a, mit einem Sensor 9. hier einem Kraftsensor oder einem Wegsensor, gekoppelt. Mit diesem Sensor 9 wird an zentraler Stelle der Blende eine Bewegung der Blende 6 in Richtung einer Tastflächenbetätigung erfasst. Um eine Bewegung in eng begrenztem Maße bereitzustellen, ist die Blende 6 mit einem elastischen Mittel 10 an dem ortsfesten Gerätegehäuse 2 angebracht. Damit kann das gesamte Blendenteil 6 etwas in Richtung D der Tastenbetätigung bewegt werden, vorzugsweise ist der Bewegungsbereich auf einen Wert von 0,2 mm bis 2 mm begrenzt, sodass die schwimmende Anbindung an das Gehäuse 2 vom Benutzer nur gering wahrnehmbar ist bzw. nur bei einer Bedienhandlung.

Alternativ kann die Befestigung der Blende mittels federnder Bauelemente, beispielsweise Schraubenfedern oder Blattfedern, erfolgen. Das Entspannen von metallischen Federn erfordert in der Regel geringere Zeiten gegenüber Kunststoffkomponenten, sodass eine sehr zuverlässige und dauerhaft funktionierende Anordnung geschaffen wird.

Der Sensor 9 ist in dieser Ansicht von der Blende 6 verdeckt, da er oben - mittig hinter der Blende 6 liegt. Der Sensor 9 ist dabei am Gerätegehäuse 2 und an der Blende 6 gekoppelt oder befestigt, um eine Relativbewegung der Blende 6 zum Gehäuse 2 zu erfassen. In einer bevorzugten Ausführung ist die Blende 6 mit einem Display 8 zur Anzeige von Informationen oder Gerätezuständen versehen.

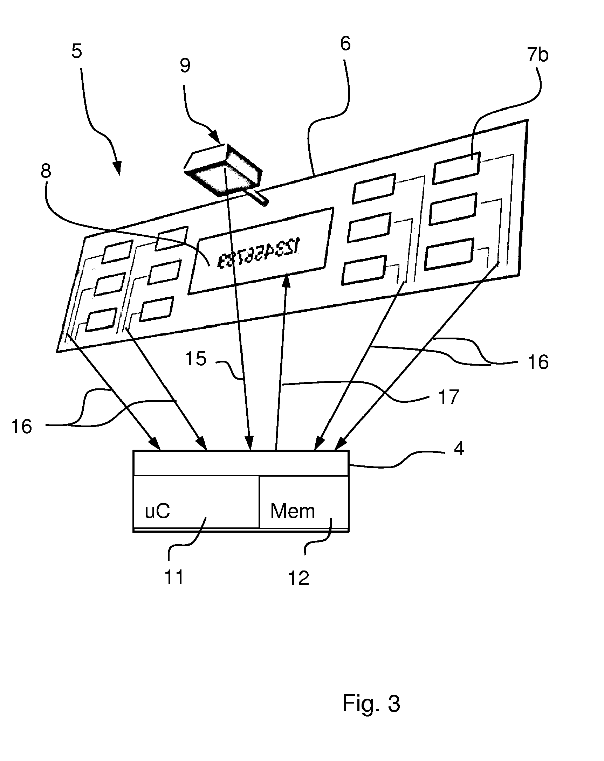

Fig. 3 zeigt die Blende 6 von der Rückseite oder Innenseite. Die Blende 6 ist mit einer leitfähigen Beschichtung 7b versehen, um die berührsensitiven Schaltflächen 7 bereitzustellen und bei Berührung eine Änderung des elektrischen Widerstandes, Kapazität, Strom oder Spannung zu bewirken, die wiederrum von der Steuereinrichtung 4 erfasst und entsprechend ausgewertet wird. Es kann alternativ auch ein Berührbildschirm, auch TouchScreen genannt, an der Blende 6 angeordnet werden oder die Blende selbst bilden. Die Steuereinrichtung 4 umfasst dabei vorzugsweise einen Mikrocontroller 11 mit einem Speicher 12, um die Bedienfunktionen oder zusätzlich Gerätefunktionen bzw. Anzeigefunktionen für das Display 8 bereitzustellen. Der weitere Sensor 9, der die Kraftbeaufschlagung auf der Blende 6 erfasst, ist signaltechnisch, angedeutet mit dem Pfeil 15, mit der Steuereinrichtung 4 verbunden, sodass aus der Kombination, beispielsweise einer logischen UND-Verknüpfung, aus der erfassten Berührung einer Berührfläche 7 mit der globalen Druckbeaufschlagung die Entscheidung über das Bedienereignis durch die Steuereinrichtung 4 bzw. dem programmierten Mikrocontroller 11 getroffen wird. Die Pfeile 16 skizzieren die Signalverbindungen oder Leitungen zwischen den Berührsensitiven Flächen 7 bzw. den leitfähigen Schichten 7b und der Steuereinrichtung 4 bzw. dem Mikrocontroller 11. Ferner ist mit dem weiteren Pfeil 17 die Signal oder Datenverbindung zum Display oder einer Anzeigeeinrichtung skizziert, wobei die reale Datenverbindung in der Regel eine Mehrzahl von Leitungen umfasst.

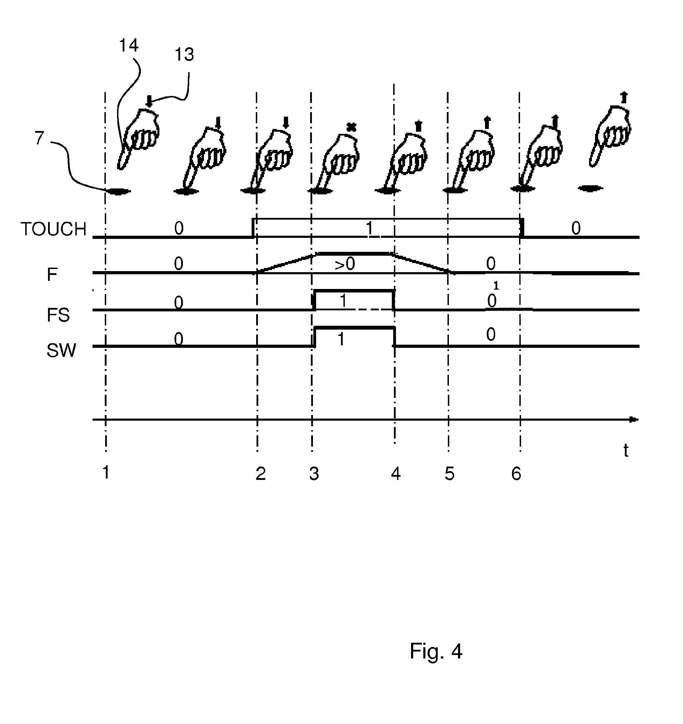

Fig. 4 zeigt als Diagramm beispielhaft den Ablauf einer Betätigung einer Schaltfläche 7 mit den einzelnen Signalen aufgrund der Auswertung dazu. Zum Zeitpinkt t=1 ist der Finger des Benutzers von der Blende 6 bzw. von der Berührfläche 7 entfernt. Mit dem Pfeil 13 ist angedeutet, dass der Finger 14 sich in Richtung Berührfläche oder Betätigungsfläche 7 bewegt. Ab dem Zeitpunkt t=2 berührt der Finger die ausgewählte Fläche 7, sodass das Berührsignal TOUCH aktiv wird. Ferner ist zu erkennen, dass sich ab dem Zeitpunkt t=2 die Kraftbeaufschlagung F auf die Blende 6 erhöht. Bei Errechnen eines vorbestimmten Grenzwertes zum Zeitpunkt t=3 wird eine Kraftbeaufschlagung bzw. die Schwelle oder Grenzwert für die Beurteilung einer Kraftbeaufschlagung durch den Sensor 9 erkannt und als Signal FS der Steuereinrichtung 4 zugeführt. Diese wiederrum erkennt das Bedienereignis SW aus der logischen UND-Verknüpfung des Sensorsignals FS und dem individuell der jeweiligen Schaltfläche 7 zugeordneten Touch-Signal TOUCH. Ab dem Zeitpunkt t=4 wird der Druck auf die Schaltfläche 7 nachgelassen, also der Tastvorgang wird beendet. Zu erkennen ist, dass die Kraftbeaufschlagung F auf die Außenfläche 6a der Blende 6 stetig nachlässt oder absinkt. Das vom Sensor 9 generierte Sensorsignal FS nimmt dabei wieder den Zustand 0, also deaktiviert ein. Auch das Schaltsignal SW wird ab dem Zeitpunkt t=4 deaktiviert, wodurch das allmähliche Loslassen eines normalen federbelasteten Tasters nachempfunden wird. Ab dem Zeitpunkt t=5 ist die Kraftbeaufschlagung F auf die Außenfläche 6a der Blende 6 beendet, wobei der Finger 14 noch auf der Tastfläche 7 aufliegt. Das Signal TOUCH der berührsensitiven Auswertung ist noch weiterhin aktiv bis zum Zeitpunkt t=6. Ab diesem Zeitpunkt liegt der Finger 14 nicht mehr auf der Berührfläche 7, sodass das Signal TOUCH deaktiviert bzw. auf 0 gesetzt wird. Der Schaltvorgang oder das Schalt- oder Tastereignis ist jedoch schon bei t=4 beendet.

## Patentansprüche

1. Bedienvorrichtung (5) für ein elektrisches oder elektronisches Gerät (1), umfassend ein Blendenteil (6) mit Betätigungsflächen (7), einer Steuereinrichtung (4) und einer Anordnung von Sensoren (7), die jeweils den Betätigungsflächen (7) zugeordnet sind und dazu ausgebildet sind, bei Berührung oder Kraftbeaufschlagung einer Schaltfläche (7) oder bei Annäherung an eine Schaltfläche (7) eine elektrische Größe wie beispielsweise Kapazität, Widerstand, Strom oder Spannung zu erfassen und als Schaltsignal zur Auswertung der Schaltposition der Steuereinrichtung (4) zuzuführen, **gekennzeichnet durch**
zumindest einen weiteren Sensor (9), der dazu ausgebildet ist, eine Kraftbeaufschlagung auf die Blende (6) bzw. auf eine der jeweiligen Betätigungsfläche (7) zu erfassen und als weiteres Signal (FS) der Steuereinrichtung (4) zuzuführen zu einer zusätzlichen Bewertung des Bedienereignisses.

2. Bedienvorrichtung (5) nach Anspruch 1,
**dadurch gekennzeichnet**
**dass** der zusätzliche Sensor (9) zumindest ein Kraftsensor ist, der dazu geeignet und ausgebildet ist, eine Kraftbeaufschlagung auf der Außenseite (6a) des Blendenteils (6) zu erfassen.

3. Bedienvorrichtung (5) nach Anspruch 1,
**dadurch gekennzeichnet**
**dass** der zusätzliche Sensor (9) zumindest ein Wegsensor ist, der dazu geeignet und ausgebildet ist, bei Krafteinwirkung auf der Außenseite (6a) des Blendenteils (6) eine Lageänderung oder Verformung der Blende (6) zu erfassen.

4. Bedienvorrichtung (5) nach Anspruch 1, 2 oder 3,
**dadurch gekennzeichnet, dass** das Blendenteil (6) Mittel (10) zur schwimmenden Lagerung oder Kopplung an einem Gehäuse (2) des elektrischen Gerätes (1) aufweist.

5. Bedienvorrichtung (5) nach Anspruch 4,
**dadurch gekennzeichnet, dass** als Mittel (10) zur schwimmenden Lagerung eine elastische Dichtung zur Anlage des Blendenteils (6) an dem feststehenden Gehäuse (2) des Gerätes (1) vorgesehen ist.

6. Bedienvorrichtung (5) nach Anspruch 4,
**dadurch gekennzeichnet, dass** als Mittel (10) zur schwimmenden Lagerung federnde Befestigungselemente vorgesehen sind.

7. Bedienvorrichtung (5) nach eine der Ansprüche 1 bis 6,
**dadurch gekennzeichnet, dass**
das Blendenteil (6) als verformbare Platte ausgebildet ist.

8. Bedienvorrichtung (5) nach einem der Ansprüche 1 bis 7,
**dadurch gekennzeichnet,**
**dass** die Verformbarkeit bzw. Bewegung des Blendenteils (6) senkrecht zur Außenfläche (6a) des Blendenteils (6) im Bereich von 0,2 mm bis 2 mm liegt.

9. Bedienvorrichtung (5) nach einem der Ansprüche 2 bis 8,
**dadurch gekennzeichnet,**
**dass** der Kraftsensor (9) an der Blende (6) angekoppelt ist und ferner zur Kopplung mit dem ortsfesten Gehäuse (2) des Gerätes (1) ausgebildet ist, um im betriebsgemäßen Zustand eine Verformung oder Bewegung der Blende (6) in Richtung Tastflächenbetätigung, also senkrecht zur Erstreckung der Außenfläche (6a) der Blende (6), zu erfassen.

10. Bedienvorrichtung (5) nach Anspruch 1 oder 2,
**dadurch gekennzeichnet,**
**dass** der weitere Sensor (9) dazu ausgebildet ist, eine Verformung oder Bewegung der Blende (6) beim Eindrücken und eine entgegengesetzte Bewegung oder Verformung der Blende (6) beim Loslassen zu erfassen und der Steuereinrichtung (4) als Signal zuzuführen zur Bestimmung des Bedienereignisses.

11. Bedienvorrichtung (5) nach Anspruch 2,
**dadurch gekennzeichnet,**
**dass** der Kraftsensor (9) rückseitig im mittleren Bereich mit der Blende (6) gekoppelt oder befestigt ist, bezogen auf die Erstreckung der Blende von einem seitlichen Ende (61) zum gegenüberliegendem seitlichen Ende (62).

12. Bedienvorrichtung (5) nach Anspruch 2,
**dadurch gekennzeichnet,**
**dass** der Kraftsensor (9) rückseitig an einem seitlichen Ende (61) der Blende (6) und ein weiterer Kraftsensor rückseitig am gegenüberliegenden, seitlichen Ende (62) der Blende (6) gekoppelt oder befestigt ist.

13. Bedienvorrichtung (5) nach einem der Ansprüche 1 bis 12,
**gekennzeichnet durch**
ein akustisches Ausgabemittel welches dazu ausgebildet ist, ein akustisches Signal im erfassten Betätigungsfall auszugeben.

14. Elektrisches Gerät (1), wie Gargerät (1), Getränkebereiter, Waschmaschine, Trockner, Geschirrspüler oder Desinfektionsgerät, umfassend eine Bedieneinrichtung (5) nach einem der Ansprüche 1 bis 13, die mit einer Steuereinrichtung (4) in Wirkverbindung steht zur Einstellung und zum Betreiben des elektrischen Gerätes (1)..
